(19) Europäisches Patentamt
European Patent Office
Office européen des brevets

(11) Veröffentlichungsnummer: **0 278 250**
**A1**

(12) **EUROPÄISCHE PATENTANMELDUNG**

(21) Anmeldenummer: **88100460.0**

(51) Int. Cl.$^4$: **G01R 27/02**

(22) Anmeldetag: **14.01.88**

(30) Priorität: **20.01.87 DE 3701472**

(43) Veröffentlichungstag der Anmeldung:
**17.08.88 Patentblatt 88/33**

(84) Benannte Vertragsstaaten:
**AT CH DE FR GB IT LI NL SE**

(71) Anmelder: **Siemens Aktiengesellschaft Berlin und München**
**Wittelsbacherplatz 2**
**D-8000 München 2(DE)**

(72) Erfinder: **Hieber, Konrad, Dr.**
**Laubensteinstrasse 7**
**D-8214 Bernau(DE)**

(54) **Verfahren zur Endpunkt-Kontrolle von durch im Plasma aktivierte Ionen, Radikale und/oder neutrale Teilchen bewirkten Ätzprozessen, an elektrisch isolierenden Schichten, insbesondere bei höchst integrierten Halbleiterschaltungen.**

(57) Bei einem Verfahren zur Endpunkt-Kontrolle von durch im Plasma aktivierte Ionen, Radikale und/oder neutrale Teilchen bewirkten Ätzprozessen (sogenanntes Trockenätzen) an elektrisch isolierenden Schichten wird der Endpunkt des Materialabtrages mit Hilfe eines auf dem beweglichen Substrathalter (7, 17) im Rezipienten (22) befindlichen Referenzsubstrates von definierter Probengeometrie durch Messung des elektrischen Widerstandes dadurch bestimmt, daß der Spannungsabfall $U_{M1}$ eines in bekannten Zeitabständen in die unter der abzutragenden Schicht liegende elektrisch leitende Schicht eingeprägten bekannten konstanten Stromes $I_{M1}$ gemessen wird und die Messung solange fortgesetzt wird, bis der durch das Plasma in die leitende Schicht zusätzlich injizierte Strom $I_{inj}$ den Spannungsabfall verändert. Die Meßdaten werden berührungsfrei durch elektromagnetische Strahlung im Pulscode-Modulationsverfahren übertragen, wobei ein telemetrisches Meßsystem (18) verwendet wird, welches als unabhängige Einheit an den beweglichen Substrathalter (7, 17) montiert ist. Auf diese Weise kann eine lokale Endpunktkontrolle im Plasma durchgeführt werden und gegebenenfalls der Ätzprozeß über die Ätzrate mit Hilfe eines Prozeßrechners (30) gesteuert werden. Durch die direkt an der abzutragenden Schicht (1, 11) durchgeführten Messungen entfallen die bis jetzt am Plasma vorgenommenen, schwierig durchzuführenden Untersuchungen. Das Verfahren wird verwendet bei der Herstellung von Strukturen von dielektrischen Schichten im subμm-Bereich.

FIG 5

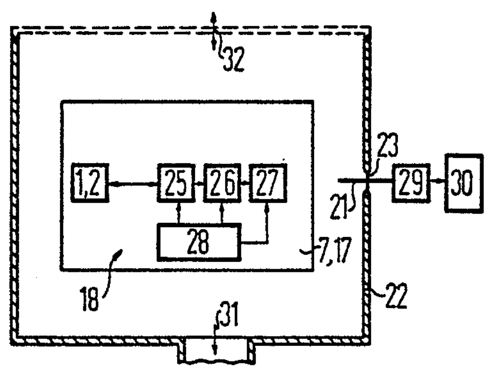


EP 0 278 250 A1

# Verfahren zur Endpunkt-Kontrolle von durch im Plasma aktivierten Ionen, Radikale und/oder neutrale Teilchen bewirkten Ätzprozessen, insbesondere für höchstintegrierte Halbleiterschaltungen.

Die Erfindung betrifft ein Verfahren zur Kontrolle von durch im Plasma aktivierte Ionen, Radikale und neutrale Teilchen bewirkten Ätzprozessen, wie sie insbesondere bei der Strukturierung von für höchstintegrierte Halbleiterschaltungen verwendete, auf metallisch leitende Schichten aufgebrachte elektrisch isolierende Schichten mit Photolackmaskierung verwendet werden, durch Bestimmung des Endpunktes des Materialabtrages der auf einem Substrat befindlichen zu ätzenden Schicht während des Materialabtrages im Plasma, bei dem als Ätzreaktor ein evakuierter Rezipient mit evakuierbarer Schleusenkammer verwendet wird und bei dem der die zu ätzenden Substrate tragende Substrathalter beweglich ausgebildet ist.

Die gezielte und maßgetreue Strukturierung dünner isolierender Schichten durch im Plasma aktivierte Ionen, Radikale und/oder neutrale Teilchen bewirkter Ätzprozesse (sogenanntes Trockenätzen) ist ein kritischer Prozeßschritt bei der Herstellung höchstintegrierter Halbleiterbauelemente, wie aus dem Buch "VLSI-Technology" von S. M. Sze, Mc-Graw-Hill, Int. Book Comp. (1984) im Kapitel "Dry Etching", insbesondere auf den Seiten 305, 306 und 307 zu entnehmen ist.

Bei dem sogenannten Trockenätzverfahren befindet sich auf der zu strukturierenden Schicht bzw. auf dem zu strukturierenden Substrat bereits eine strukturierte Schicht aus Photolack. Das Problem besteht nun darin, die Struktur des Photolackes in die darunterliegende Schicht aus isolierendem Material maßgetreu zu übertragen. Dazu wird das lokal mit Photolack beschichtete Substrat mit geeigneten Ionen beschossen, bzw. in ein Plasma ein gebracht. Die im Plasma chemisch aktivierten Teilchen (Ionen und Neutrale) reagieren mit dem freiliegenden Schicht-bzw. Substratmaterial unter Bildung einer flüchtigen Verbindung derart, daß ein lokaler Materialabtrag erfolgt. Der lokale Materialabtrag kann auch durch einfache Stoßprozesse der Atome, Ionen oder Moleküle (Zerstäuben bzw. Sputtern) unterstützt werden.

Bei der Entwicklung von Ätzprozessen ist darauf zu achten, daß die Reaktivität des Plasmas durch geeignete Wahl der Ausgangsgase derart gewählt wird, daß die Abtragrate für den Photolack bzw. für das unter der zu strukturierenden Schicht liegende Material möglichst gering ist. Dies bedeutet, daß für jedes Schichtmaterial ein eigener Ätzprozeß entwickelt werden muß. Da ferner eine extrem hohe Reproduzierbarkeit für die geringen maßlichen Toleranzen (zum Beispiel ± 0,1 µm) gefordert wird, müssen die Prozesse ständig überwacht werden. Insbesondere muß der Endpunkt der Ätzung genau bestimmt werden.

Aufgabe der Erfindung ist es daher, ein Kontrollverfahren anzugeben, mit dem es möglich ist, diese Bedingung zu erfüllen.

Bisher wurden zur Ermittlung des Endpunktes der Ätzung hauptsächlich spektrometrische Verfahren zur Charakterisierung des Plasmas verwendet (siehe S. M. Sze, VLSI-Technology, Mc-Graw-Hill, Int. Book Comp. (1984), Seite 334). Dabei ist es wesentlich, im Plasma die Emissions-oder Absorptionslinie eines Moleküls zu finden, die für den jeweiligen Ätzprozeß charakteristisch ist. Die Intensität dieser Linie nimmt rasch ab, wenn das zu ätzende Material vollständig beseitigt ist. Aus der Zeit bis zur Intensitätsabnahme läßt sich - bei bekannter Schichtdicke - die Ätzrate errechnen. Es ist dabei offensichtlich, daß bei diesen Verfahren über das Ätzverhalten aller Scheiben in der Anlage gemittelt wird. Für die lokale Bestimmung der Ätzrate müssen Proben entnommen werden, um den Materialabtrag zum Beispiel im Rasterelektronenmikroskop zu ermitteln. Eine lokale Charakterisierung des Plasmas ist sehr schwierig, da durch die notwendigen Sonden (zum Beispiel Langmuir-Sonden) das Plasma selbst zu stark beeinflußt wird (nähere Einzelheiten siehe Aufsatz von Clements im J. Vac. Sci. Technol. 15 (2) März/April 1978, Seiten 193 bis 198).

Die Erfindung beschreitet einen anderen Weg zur Bestimmung des Endpunktes bei Trockenätzprozessen an elektrisch isolierenden Schichten und ist durch ein Verfahren der eingangs genannten Art dadurch gekennzeichnet, daß der Endpunkt des Materialabtrages mit Hilfe eines Referenzsubstrates definierter Probengeomêtrie mit niederohmigen Kontakten durch Messung des Schichtwiderstandes $R_{M1}$ dadurch bestimmt wird, daß der Spannungsabfall $U_{M1}$eines in bestimmten Zeitabständen in die metallisch leitende Schicht eingeprägten bekannten, konstanten Stromes $I_{M1}$ gemessen wird und die Messung solange fortgesetzt wird, bis der durch die Ionen und Elektronen des Plasmas in die metallisch leitende Schicht zusätzlich injizierte Strom $I_{inj}$ den Spannungsabfall $U_{M1}$verändert. Die Meßdaten werden berührungsfrei durch elektromagnetische Strahlung im Pulscodemodulationsverfahren (PCM-Verfahren) übertragen, wobei ein telemetrisches Meßsystem verwendet wird, welches als unabhängige Einheit an dem beweglichen Substrathalter montiert ist.

Die Erfindung macht sich die Erkenntnis zunutze, daß, solange sich noch über der metallisch leitenden Schicht eine zusammenhängende, dichte, elektrisch isolierende Schicht befindet, aus dem

Plasma keine elekrischen Ladungen in die metallisch leitende Schicht injiziert werden (Eindringtiefe der Ionen oder Elektronen ca. 1 Monolage des Schichtmaterials). Dies bedeutet, daß der Schichtwiderstand $R_{M1}$, bestimmt durch den Quotienten des gemessenen Spannungsabfalles $U_{M1}$ und des in kurzen Zeitabständen (0,1 sce) eingeprägten konstanten Stromes $I_{M1}$ dem wahren Schichtwiderstand $R_W$ entspricht. Ist die zu ätzende, elektrisch isolierende Schicht abgetragen, so werden sofort die elektrisch geladenen Teilchen aus dem Ätzplasma einen Strom $I_{inj}$ in die metallisch leitende Schicht einprägen, der sich dem Meßstrom $I_{M1}$ überlagert und den gemessenen Spannungsabfall $U_{M1}$ verfälscht. Der Schichtwiderstand $R_M$ berechnet sich dann gemäß der Formel

$$R_M = \frac{U_{M1}}{I_{M1} + I_{inj}} \neq R_{M1}$$

Dies bedeutet, daß bei konstantem Meßstrom $I_{M1}$ eine plötzliche Widerstandsänderung eindeutig die vollständige Entfernung der zu ätzenden, elektrisch isolierenden Schicht anzeigt. Eine analoge Messung, aber für einen Schichtaufbau einer metallischen Schicht ist aus der europäischen Patentanmeldung 0 146 720 zu entnehmen.

Die Abhängigkeit des Endpunktes des Materialabtrages von der Größe der zu strukturierenden Bereiche läßt sich kontrollieren, wenn zum Beispiel auf dem Referenzsubstrat unterschiedlich große Photolackmaskierungsbereiche erzeugt, anschließend trockengeätzt und elektrisch vermessen werden.

Im Rahmen der Erfindung soll es auch liegen, die lokale Ätzrate von dielektrischen Schichten zu ermitteln,wobei die jeweilige Dicke der Schicht des Referenzsubstrates vorher bestimmt werden muß.

Im folgenden wird die Erfindung anhand von zwei Ausführungsbeispielen und einem Meßbeispiel und der Figuren 1 bis 6 noch näher erläutert. Dabei zeigen

die Figuren 1 und 3 das für die Messung vorgesehene Referenzsubstrat mit Meßkontakten in Draufsicht, wobei Figur 1 eine feinstrukturierte Photolackschicht auf einer elektrisch isolierenden Schicht und Figur 3 eine grob strukturierte Photolackschicht enthält,

die Figuren 2 und 4 die entsprechenden Schnittbilder zu den Figuren 1 und 3,

die Figur 5 den funktionellen Zusammenhang des Meßsystems und seiner Anordnung in bzw. zu der Ätzanlage und

die Figur 6 den bei einer bestimmten Zeit (ca. 120 sec.) erfolgten Spannungsabfall $U_{M1}$ der den Endpunkt der Ätzung der dielektrischen Schicht anzeigt.

In allen Figuren sind gleiche Teile mit gleichen Bezugszeichen versehen.

Die Messungen werden wie folgt durchgeführt: Auf eine Referenzsubstratscheibe (siehe Figuren 1 bis 4) wird die zu strukturierende Schicht zum Beispiel aus $SiO_2$ völlig analog zu den für die Herstellung der integrierten Schaltung vorgesehenen Halbleiterkristallscheiben auf eine metallisch leitende Schicht, zum Besipiel aus dotiertem Silizium, Metallsilizid oder einer Aluminium-Legierung aufgebracht und mit der Photolackmaskierung versehen. Nun wird die gesamte oder ein Teilbereich der Referenzsubstratscheibe in das Telemetriesystem (siehe Figur 5) eingebaut und elektrisch kontaktiert.

Da das Telemetriesystem in der Anlage genauso bewegt wird wie die zur Bearbeitung anstehenden Halbleiterkristallscheiben, erhält man aus dem zeitlichen Verlauf der Widerstands-($R_{M1}$ ) bzw. Spannungsmessung ($U_{M1}$) an der elektrisch leitenden Schicht die Information über den Endpunkt der Ätzung der elektrisch isolierenden Schicht.

Die Figuren 1 bis 4 zeigen das für die Messung verwendete Referenzsubstrat, wobei folgende Bezugszeichen gelten:

1 = abzutragende $SiO_2$-Schicht,
2 = metallisch leitende Schicht auf dem Substrat,
3 = feinstrukturierte Photolackschicht,
4 = niederohmige Kontaktelektroden für die Messung,
13 = grobstrukturierte Photolackschicht.

Um eine eventuelle Abhängigkeit der Ätzrate von der Größe der zu strukturierenden Bereiche zu ermitteln, werden auf dem Referenzsubstrat unterschiedlich große Photolackstrukturen erzeugt, anschließend geätzt und elektrisch vermessen. Ist die Summe der Breite der schmalen freiliegenden S $iO_2$-Stege 1 in Figur 1 und 2 gleich der Breite des breiten $SiO_2$-Steges 11 in Figur 3 und 4, so kann bei unterschiedlichem zeitlichem Verlauf des gemessenen Widerstandes der elektrisch leitenden Schicht 2 bzw. 12 direkt auf einen Unterschied in der Ätzrate geschlossen werden.

Bezüglich Figur 5 wird auf die in dem europäischen Patent 0 067 432 dargestellte Anordnung verwiesen. Wie aus der Figur 5 zu entnehmen ist, stellt das in eine Doppelpalette 7, 17 eingebaute Meßsystem 18 mit dem Sender 27 ein unabhängiges System dar. Die Meßdatenübertragung von der rotierenden Palette 7, 17 erfolgt über das Telemetriesystem, wobei sich der Umsetzer, der

die Meßspannung, die an der Schicht 1, 2 gemessen worden ist, in übertragungsfähige Puls-Code-Modulations-Signale verwandelt unter der Palette befindet. Die Meßapparatur (18) einschließlich Sender 27 wird mit einer Batterie 28 betrieben. Die Empfangsantenne 21 wird bei Verwendung von HF-Technik bei der Meßdatenübertragung innerhalb des Rezipienten 22 angebracht und über eine isolierte Vakuumdurchführung 23 aus dem Rezipienten 22 herausgeführt. Die Einheit zur Aufbereitung der empfangenen telemetrischen Daten, der Empfänger 29, befindet sich außerhalb der Anlage (22). Die Meßdaten können dann als digitale oder analoge Signale zur Auswertung vorliegen. Wenn die Meßdaten digital vorliegen, können sie direkt von einem Computer 30 übernommen werden, der die sofortige Auswertung übernimmt und den Ätzprozeß zum gewünschten Zeitpunkt stoppt.

In dem in Figur 5 dargestellten Blockdiagramm über den Meßablauf gelten folgende Bezugszeichen:

1, 2 = abzutragende Schicht auf einem metallisch leitenden Substrat,
25 = Widerstandsmessung und/oder Spannungsmessung,
26 = Umsetzer (PCM-Modulator),
27 = Sender,
28 = Stromversorgung,
21 = Empfangsantenne,
23 = isolierte Vakuumdurchführung zur Antenne,
29 = Empfänger,
30 = Computer.

Der einfache Pfeil 31 in Figur 5 kennzeichnet den Vakuumanschluß des Rezipienten 22, der Doppelpfeil 32 die angebaute Schleusenkammer.

Meßbeispiel:

Die leitende Schicht besteht aus dotierten polykristallinen Silizium mit einem spezifischen Widerstand rho = 800 µOhm cm und der Schichtdicke d = 0,4 µm.

Es errechnet sich $R_{M1} = \frac{rho}{d} = 20$ Ohm square = $R_W$

Der Meßstrom: $I_{M1}$ beträgt 10 mA, die Spannung $U_{M1}$ = 200 mV.

Die isolierende Schicht besteht im Ausführungsbeispiel aus einer 0,8 µm dicken Siliziumoxidschicht.

Die Ätzrate einer Einzelscheibenanlage beträgt 0,4 µm/min aus

$$R_W = \frac{U_{M1}}{I_{M1} + I_{inj}}$$

errechnet sich

$$I_{inj} = \frac{U_{M1}}{R_W} - I_{M1}$$

$I_{inj}$ = - 3mA

**Ansprüche**

1. Verfahren zur Kontrolle von durch im Plasma aktivierte Ionen, Radikale und/oder neutrale Teilchen bewirkten Ätzprozessen, wie sie insbesondere bei der Strukturierung von für höchstintegrierte Halbleiterschaltungen verwendete, auf metallisch leitende Schichten (2) aufgebrachte, elektrisch isolierende Schichten (1, 11) mit Photolackmaskierung (3, 13) verwendet werden, durch Bestimmung des Endpunktes des Materialabtrages der auf einem Substrat (2) befindlichen zu ätzenden Schicht (1, 11) während des Materialabtrages im Plasma, bei dem als Ätzreaktor ein evakuierter (31) Rezipient (22) mit einer evakuierbaren Schleusenkammer (32) verwendet wird und bei dem der die zu ätzenden Substrate (1, 2) tragende Substrathalter (7, 17) beweglich ausgebildet ist, **dadurch gekennzeichnet,** daß der Endpunkt des Materialabtrages mit Hilfe eines Referenzsubstrates (1, 2) definierter Probengeometrie mit niederohmigen Kontakten (4) durch Messung des Schichtwiderstandes $R_{M1}$ dadurch bestimmt wird, daß der Spannungsabfall ($U_{M1}$) eines in bestimmten Zeitabständen in die metallisch leitende Schicht eingeprägten konstanten bekannten Meßstromes ($I_{M1}$) gemessen wird und die Messung solange fortgesetzt wird, bis der durch die Ionen und Elektronen des Plasmas in die metallisch leitende Schicht (2) zusätzlich injizierte Strom ($I_{inj}$) den Spannungsabfall ($U_{M1}$) verändert.

2. Verfahren nach Anspruch 1, **dadurch gekennzeichnet,** daß die Messungen in einem Zeitintervall von 0,01 bis 1 Sekunde, vorzugsweise von 0,2 Sekunden durchgeführt werden.

3. Verfahren nach Anspruch 1 und/oder 2, **dadurch gekennzeichnet,** daß die Meßdaten berührungsfrei durch elektromagnetische Strahlung im Pulscode-Modulations-Verfahren (PCM-Verfahren) übertragen werden, wobei ein telemetrisches

Meßsystem (18) verwendet wird, welches als unabhängige Einheit an dem beweglichen Substrathalter (7, 17) montiert ist.

4. Verfahren nach Anspruch 1 bis 3, **dadurch gekenn zeichnet,** daß aus den Meßdaten in Abhängigkeit von der Zeit die lokale Ätzrate berechnet wird.

5. Verfahren nach Anspruch 1 bis 4, **dadurch gekennzeichnet,** daß die Meßwerte über einen Prozeßrechner (30) erfaßt und berechnet werden.

FIG 1

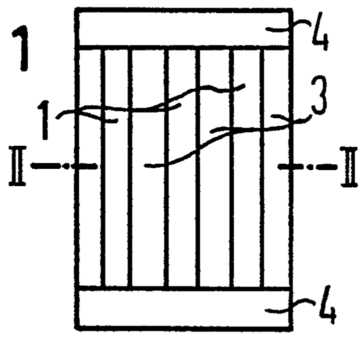


FIG 3

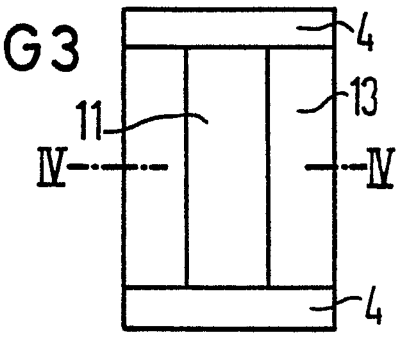


FIG 2

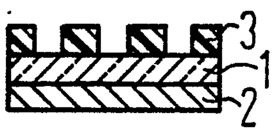


FIG 4

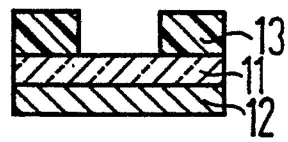


FIG 5

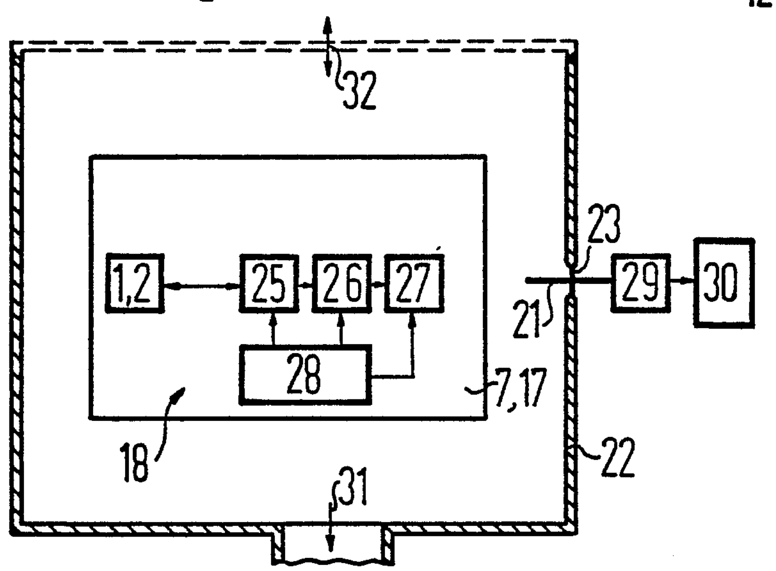


FIG 6

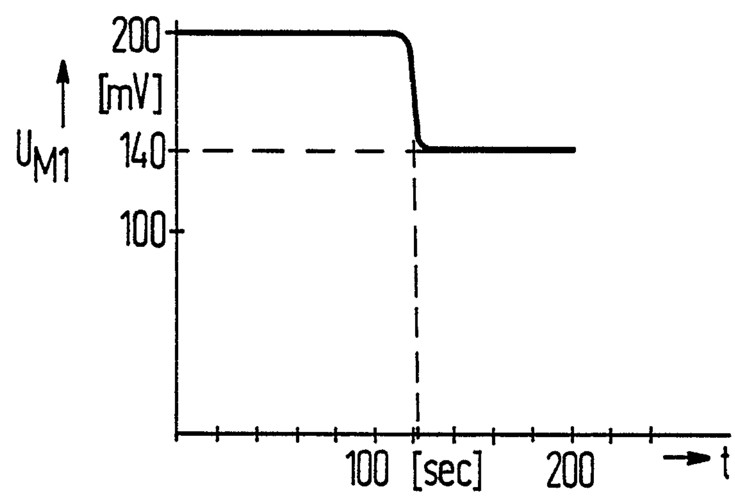

Europäisches Patentamt

# EUROPÄISCHER RECHERCHENBERICHT

Nummer der Anmeldung

EP 88 10 0460

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | EP-A-0 067 432 (SIEMENS AG) * Seite 6, Zeile 15 - Seite 8, Zeile 31; Figuren 1,2,5 * | 1,3,5 | G 01 R 27/02 |
| D,Y | EP-A-0 146 720 (SIEMENS AG) * Seite 3, Zeile 11 - Seite 6, Zeile 20; Tabelle 1; Figur 1 * | 1 | |
| A | | 2 | |
| Y | GB-A-2 076 330 (VARIAN ASSOCIATES INC.) * Seite 2, Zeile 32 - Seite 3, Zeile 56; Seite 6, Zeilen 20-61; Figuren 1,3,7c * | 1 | |
| A | | 4 | |
| A | IBM TECHNICAL DISCLOSURE BULLETIN, Band 24, Nr. 7B, Dezember 1981, Seiten 3653-3654, New York, US; E. BRETSCHER et al.: "End-point detector for dry-etch processes" * Seite 3653, Zeilen 1-17; Figur 1 * | 1 | **RECHERCHIERTE SACHGEBIETE (Int. Cl.4)** |
| A | US-A-4 103 228 (HAM) * Spalte 2, Zeile 59 - Spalte 4, Zeile 24; Figuren 1-4 * | 1 | G 01 R 27/00<br>G 01 R 19/00<br>H 01 J 37/00<br>H 01 L 23/00 |
| A | GB-A-2 052 339 (TEGAL CORP.) * Seite 2, Zeile 114 - Seite 3, Zeile 76; Figur 5 * | 4,5 | |

Der vorliegende Recherchenbericht wurde für alle Patentansprüche erstellt

| Recherchenort | Abschlußdatum der Recherche | Prüfer |
|---|---|---|
| DEN HAAG | 27-04-1988 | TRELEVEN C. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)